# EUROPEAN PATENT SPECIFICATION

(11) **EP 1 599 738 B1**
(45) Date of publication and mention of the grant of the patent: **09.05.2012**
(21) Application number: 04717346.3
(22) Date of filing: 04.03.2004
(51) Int. Cl.: G01R 31/08, G01R 31/02, H02H 3/16, H02H 3/34

(54) **DETECTION OF EARTH FAULTS IN THREE PHASE SYSTEMS**
ERKENNUNG VON ERDFEHLERN IN DREIPHASENSYSTEMEN
DETECTION DES MISES A LA TERRE DANS LES RESEAUX TRIPHASES

(30) Priority: 05.03.2003 SE 0300570
(43) Date of publication of application: 30.11.2005
(73) Proprietor: Protrol AB, 421 32 Västra Frölunda (SE)
(72) Inventor: Jan Berggren, 436 55 Hovos (SE)
(74) Representative: Johansson, Lars-Erik
(86) International application number: PCT/SE2004/000302
(87) International publication number: WO 2004/079378

(56) References cited:
- WO-A1-95/09467
- US-A- 4 529 929
- US-A- 5 839 093
- DATABASE WPI Week 200213, Derwent Publications Ltd., London, GB; Class S01, AN 2002-096150, XP002991919 & RU 2 174 690 C2 (UNIV OMSK TECH) 10 October 2001
- PATENT ABSTRACTS OF JAPAN vol. 199, no. 601 31 January 1996 & JP 07 245 869 A (HITACHI LTD) 19 September 1995
- PATENT ABSTRACTS OF JAPAN vol. 199, no. 712 25 December 1997 & JP 09 215 177 A (FUJI ELECTRIC CO LTD) 15 August 1997

## Description

### TECHNICAL FIELD

This invention is aimed for detection of earth faults in three phase high voltage electrical distribution networks, based on the detection of transient and steady state phase currents in the system.

### TECHNOLOGY POSITION

Earth faults in feeders (overhead lines and underground cables) may occur because of damages in the isolation due to ageing, or mechanical injury, as for example during digging work in the case of underground cables.

When electrical energy consumers are subjected to an outage due to faults in the distribution network the supply should be restored as soon as possible. This is the case not just for earth faults, but is also valid for short circuits between phases. It is quite common that the network topology gives the possibility for different feeding "routes", especially in rural areas, and in such cases it is important to find out which section is faulty to be able to disconnect the same and connect another section (NOP = Normally Open Point) for the alternative feeding route. A common method to restore a faulty network is to manually reconfigure the network and by trial and error find out which section has to be disconnected. This is costly, inefficient and prolongs the total outage time.

US-A-5 839 093 shows a system for locating faults and estimating fault resistance in distribution networks with tapped loads, with a direct method that calculates fault location and fault resistance directly while an iterative fashion method utilizes simpler calculations in an iterative fashion which first assumes that the phase angle of the current distribution factor Ds is zero, calculates an estimate of fault location utilizing this assumption, and then iteratively calculates a new value of the phase angle beta s of the current distribution factor Ds and fault location m until a sufficiently accurate determination of fault location is ascertained.

DATABASE WPI Week 200213, Derwent Publications Ltd., London, GB; Class S01, AN 2002-096150, XP002991919 & RU 2 174 690 C2 (UNIV OMSK TECH) 10 October 2001 shows a method suitable for non grounded MV networks, where the equipment should be placed in primary substations were the zero sequence current is measured in all feeders. Upon a fault the zero sequence current in all feeders are compared with a set value for each feeder. If one feeder zero sequence current is higher than the set value and not reversed the faulty feeder can be selected.

The available automation technology is intended for primary medium voltage substations and has, due to cost, not been utilized to any extent in secondary substations. Additionally the problem with arcing ground faults (restrikeing earth faults, intermittent earth faults) in underground cables has increased and traditional detection methods many times fail in the treatment of those.

### SUMMARY OF THE INVENTION

There is a need for a method and a device which will be able to detect and locate earth faults in three phase high voltage systems in a more simple and cost efficient way than has been known up to now.

This need is in compliance with the present innovation as it presents a method to detect single phase earth faults in three phase electrical distribution networks, which includes comparison during a predefined period of time of the change in current in one of the phases with the sum of corresponding changes in the second and third phase during the same period, where a first condition to be fulfilled is that the current change in the first phase during the predefined period of time to its amplitude or direction in a predefined way differs from the summed current change in the second and third phase in the system. The invention is defined by the features of independent claims 1 and 6. The dependent claims are directed to preferred embodiments of the invention.

In a special realization the mentioned condition is combined with a second one, which includes measurement of the zero sequence current, or rather the change thereof, and where the second condition is fulfilled when the level of the zero sequence current exceeds a predefined value during a predefined period of time. In this realization an earth fault is detected if both the first and the second requirements are fulfilled.

In another special realization the first and second conditions are combined with a third condition, which includes measurement of the steady-state zero sequence current, where the third condition is fulfilled when the zero sequence current steady-state (normally 50 or 60 Hz) amplitude exceeds a predefined level, and an earth fault is detected if the first, second and the third requirements are fulfilled.

The invention also includes arrangements for implementation of the method according to the mentioned realizations.

### DESCRIPTIONS OF FIGURES

The invention will be described more in detail in the following, with references to the attached drawings, where:

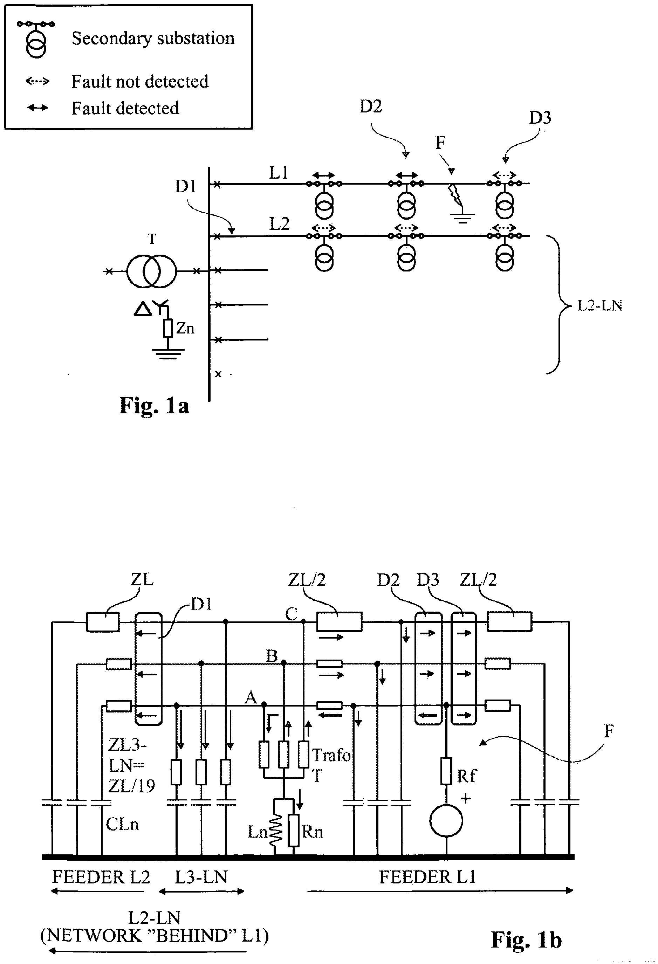

Fig. 1a and 1b show a schematically reactance grounded three phase system where an earth fault has occurred in one of the phases on feeder L1.
Fig. 1a shows a single line diagram of a distribution network with a single phase earth fault at point F where the measuring points (location for detectors) D1, D2 and D3 are indicated.

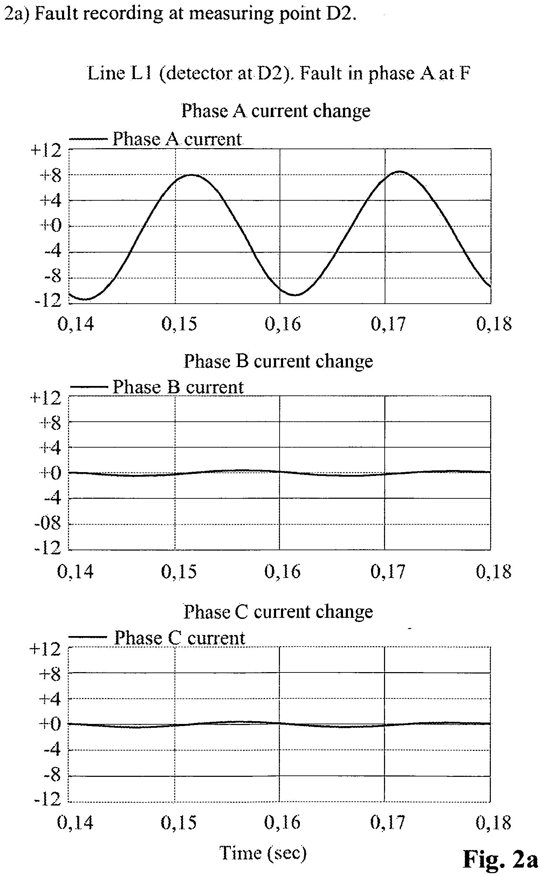

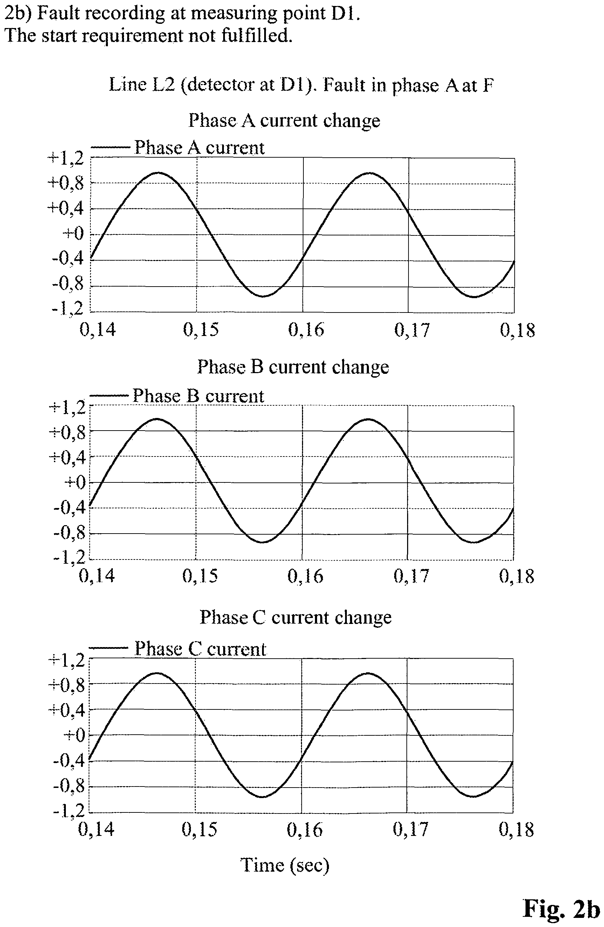

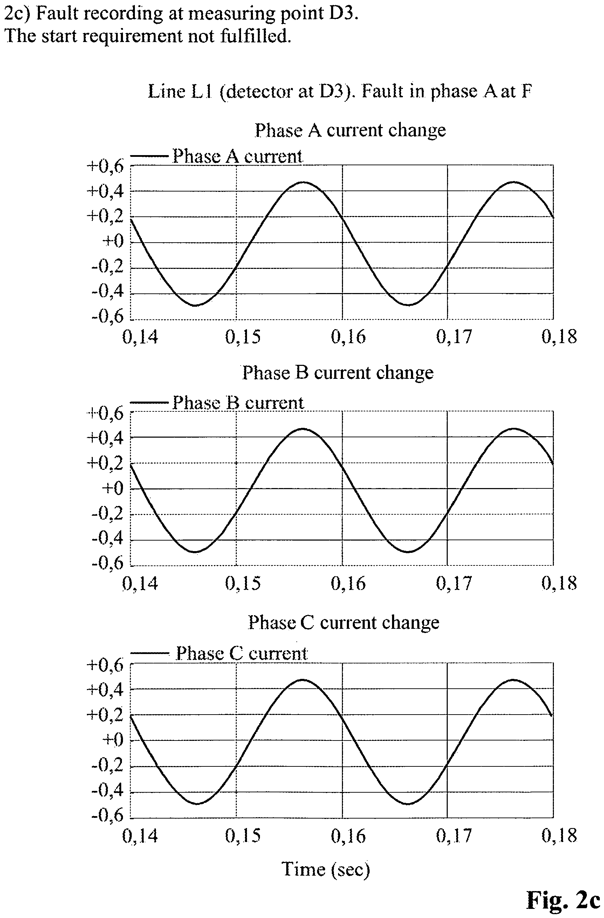

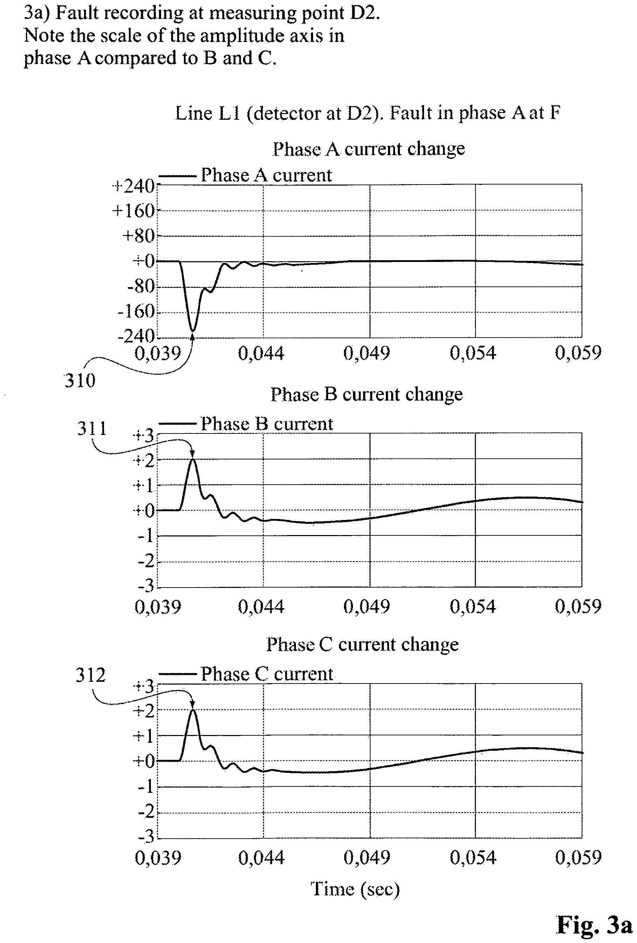

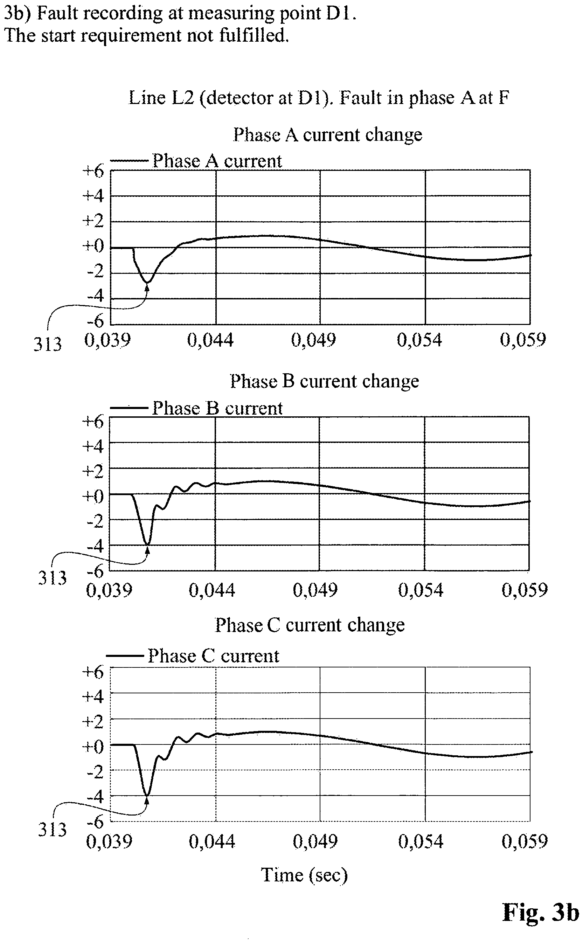

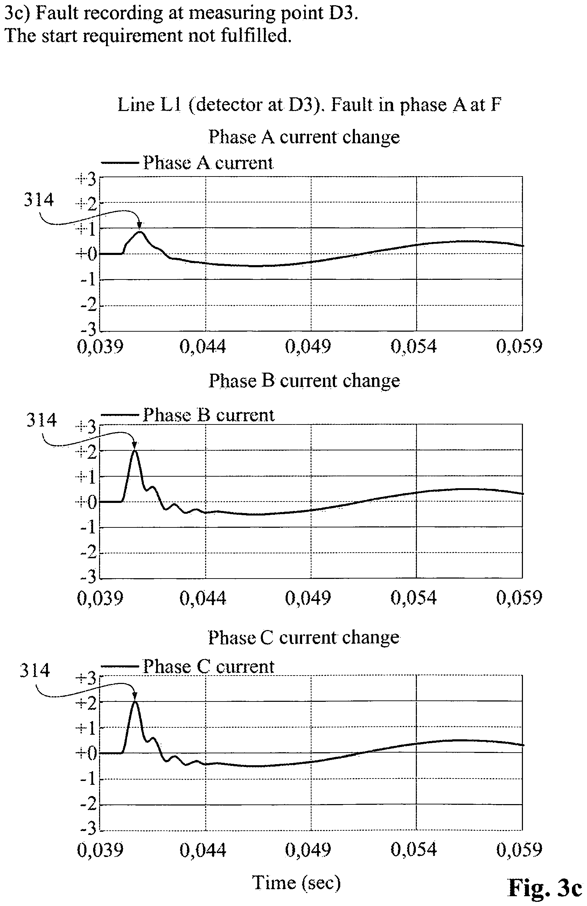

In Fig. 1b a simplified electrical model for the same network shows current changes according to Thévenins theorem. The model has been used for generation of the curves in Fig. 2 and 3. For sake of simplicity, each feeder is assumed to be 1 km corresponding to 2 Ampère (2 Ampère equals 750 m - 1.2 km PEX 3-conductor cable at 10 kV with varying conductor area). Note that all loads from Fig. 1a have been neglected and that the feeders L3-LN have been lumped together to one equivalent feeder in this model.
Fig. 2a, 2b and 2c show the steady-state currents changes in the 3 phases where the earth fault is located "in front of" the measuring point on the "own" feeder (D2), in another feeder (D1) and behind in the "own" feeder (D3), respectively. The "recordings" show the current changes with a sufficiently time period after the fault occurred enabling higher frequencies to diminish.
Fig. 3a, 3b and 3c show the initial transient currents (310-314) in the system from the same measuring points as Fig. 2a, 2b and 2c, but in another scale. The curves are filtered by a low pass filter and somewhat damped by R_{f} for the sake of "readability". The fault occurs at the time 0.04 seconds.

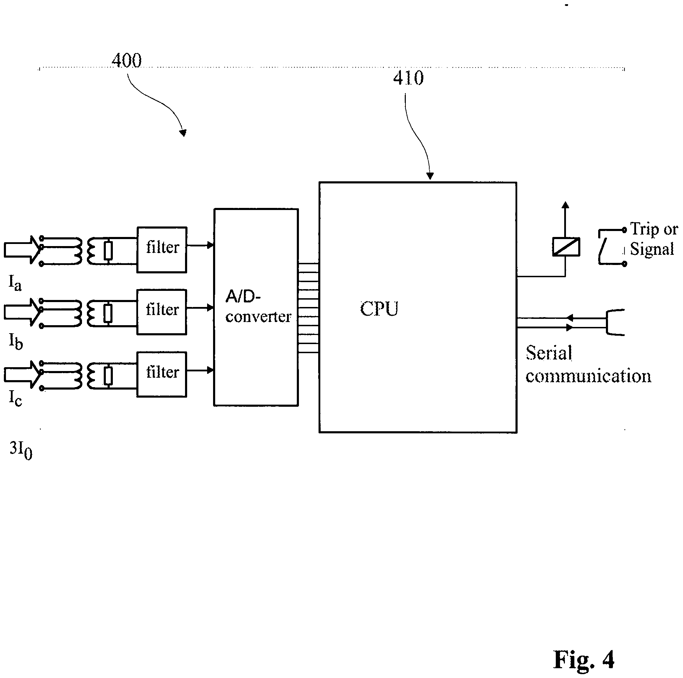

Fig. 4 shows a device (realization) according to the innovation, whereby the notation "CPU' represents means for both "number crunching" facilities and memory (RAM and ROM) for data storage and settings. The filters are aiming at reducing higher frequencies in the currents than the sampling rate allows.

### FORMS OF REALIZATION

Fig. 1a and 1b show schematically a three phase electrical distribution system, where the phases in the following will be denoted A, B and C. A transformer in the system is denoted T, and capacitances, resistances, reactances and impedances in the system are denoted C, R, L and Z, respectively.

The system is typical for a reactance grounded (Peterson coil) medium voltage network for power distribution to buildings, industries or villa quarters. Through-out the feeder the voltage is transformed down in secondary substations from the medium voltage level to a "household" level before the power is "consumed".

Let us assume an earth fault has occurred in one of the phases. An earth fault implies that current is fed from one point (the fault location) in the network to the environment which could be the surrounding territory or objects in connection with the same. The fault may have occurred due to mechanical damage, as for example during digging work, a phase conductor in contact with a tree, or ageing (treeing) which results in the lost of voltage strength in the isolation around one or three phases in underground cables.

The phase, where the earth fault has occurred, is denoted phase A, and the earth fault is shown schematically in Fig. 1a with an "arrow" at the location F.

The problem to be solved by this invention is to find out where in the network the earth fault has occurred by calculating whether the measuring position point is "electrically" located between the feeding substation and the fault location or not (FPT = Fault Pass Through). By placing measuring devices in secondary substations, where connection and disconnection is possible, one can, from a macro perspective, settle which feeder segment is the faulty one (see Fig. 1a). The purpose of the invention is the development of devices that are able to detect earth faults in high impedance grounded networks only by measuring the current without the addition of the traditionally required zero sequence voltage measurement. The benefits are the omission of the voltage transformer (which is normally not available in secondary substations), the true Fault Pass Through characteristic of the method and also its high sensitivity and discrimination of arcing ground faults.

In Fig. 2a the steady-state current changes (according to Thévenins theorem) are shown - in a measuring point between the source (the transformer T) and the fault - in the phases A, B and C caused by the earth fault in phase A at location F. The current changes noticed in phases B and C are mainly generated by the feeder capacitance to ground for the own phase conductor "forward" from the measuring point caused by the change in voltage to ground (zero sequence voltage) whereas the current change in phase A, in principle, depends on the whole network impedance to ground.

Fig. 2b shows the steady-state current changes in a measuring point located in a "healthy" part of the network (not located between the source T and the fault point F) in the phases A, B and C due to the earth fault in phase A at F. It can be seen from the graph that the current changes, in principle, are similar in amplitude and phase angle as all are caused by the own conductor capacitance to ground and the change in voltage to ground.

Fig. 2c shows the steady-state current changes in a measuring point located in the faulty feeder "forward" to the fault (in other words: not located between the source T and the fault F) in the phases A, B and C due to the earth fault in phase A at point F. It can be seen from the graph that the current changes, in principle, are similar in amplitude and phase angle as all are caused by the own conductor capacitance to ground from the part of the feeder "forward" to the measuring point and the change in voltage to ground.

The Figures 3a, 3b and 3c show mainly the same fault situation as the Figures 2a, 2b and 2c, but in the transient stage shortly after the fault has occurred (310-314) and with other scales on the axes. To clarify the initial transient phenomena the Fig. 3a, 3b and 3c have a higher resolution on the time-axis (the horizontal axis). In addition, the vertical axis in the graph in Fig. 3a, which shows the current change in phase A (310), has another scale than the graphs in Fig. 3a showing the current changes in the phases B (311) and C (312).

From Fig. 2a-2c and 3a-3c it is evident that asymmetries arise in the current changes between the three phases, which asymmetries are used by this invention to detect single phase earth faults. Except for the asymmetry shown in Fig. 2a, where it is concluded that the current change in a faulty phase conductor has a higher amplitude than the current changes in the two other phase conductors, it is also evident from Fig. 3 a that the current change in a feeder phase with an earth fault has another direction (310) than the current change in the two non-affected phases (311-312).

This can be interpreted as the "current" in the faulty phase flows in another direction with respect to the measuring point than the "currents" in the two other phases, or graphically as the "current" in the faulty phase with respect to a "zero line" (no current) flows in another direction than the "current" in the two other phases. (From Fig. 3 a it is apparent that the current change in phase A flows "upwards", whereas the two other flow "downwards". Naturally the opposite can occur, which also would indicate an earth fault in the actual feeder.)

In Fig. 4 a possible device for implementation of the method according to the invention is shown: the device includes means for connection of each of the three phases (alternatively two phases and 3I₀ from where the third phase current can be calculated. For the sake of clarity it is emphasized that this kind of set up, and also any other similar set up, must be construed to be encompassed by the expression "three phases" uses in the claims.), means for low pass filtering of the signals from the three phases at each one of these connection means, one analogue-digital converter, and a calculating unit in the form of a CPU.

The task for the device according to the invention is to detect if there is an earth fault or not located in the "forward" direction considering the measuring point and the source (FPT) by utilising the asymmetry as described above, and as concluded from Fig. 2a and 3a.

The part of the asymmetry shown in Fig. 2a and 3 a can be detected by the device in Fig. 4 by computation and comparison during a predefined period of time of the current change in a first of the system's phases, for example phase A, with the current change in the second, phase B, and third, phase C, during the same period of time.

The conditional criteria for the detection of the existence of an earth fault is a comparison whether the current change in the first phase during a predefined time period to its amplitude in a predefined way differs from the amplitude of the current changes in the second and third phase. An example of a calculation aiming at finding out whether the criteria is fulfilled or not is to see if the quotient of the highest amplitude for the highest current change in the first phase and the sum of the amplitudes for the highest current changes in the second and third phase during the same time period to its value exceeds a preset level.

The calculation can be expressed mathematically according to the following formula:

|ΔI_{A}|^/(|ΔI_{B}|^ + |ΔI_{C}|^) (1)

The quotient (1) is then compared with a suitable threshold value to find out whether there is an earth fault ("forward" to the measuring point) or not. The threshold value (the sensitivity) should be selected with respect to current changes in "legitimate loads" at the same time as the earth fault occurs, for example connection and disconnection of heat loads etc. The threshold level should in addition be set to manage reasonably high earth fault resistances R_{f}. Suitable selections for these values, R_{f}, and at the same time - within the predefined time period for comparison - appearing load changes could be, say R_{f} = 3-5 kΩ, and a 3-phase load change of 6-10 kW. On the other hand, the sensitivity must be selected such that the detection will be selective, that is the quotient (1) should not reach the threshold value when no earth fault exists or the measuring point is outside the trace between the source (T) and the fault point (F). Experiments have shown that a reasonable threshold value is in the range of 2 (1-3). Naturally it is possible within the scope of the invention to choose an arbitrary threshold value for the quotient (1), as the selected sensitivity for R_{f} and load change may vary.

The discussion above is, for the sake of simplicity, based on the steady-state asymmetry shown in Fig. 2a, but the method also combines within the scope of the invention detection of the transient asymmetry shown in Fig. 3a (310-312) by a suitable choice of filters and time period for the measurement.

The device in Fig. 4 can, if it should detect the asymmetry shown in Fig 3a, for example use the following algorithm:
The CPU detects on what side of the "zero line" the current change for the three phases is situated. (Or in other words: if the three phases range within a certain value from the "zero line" or not.) A current change above the "zero line" is given a positive value, for example "1" (310), and a current change below is given a negative value, for example "-1" (311,312). If there is no earth fault located in the "forward" direction, considering the measuring point and the source, the absolute value of the sum of the three phases is therefore 3, and when the measuring point is located between the source and the fault the absolute value of the sum gets the value 1, which makes it easy to detect the asymmetry due to an earth fault according to what can be seen in Fig. 3 a.

The alternative methods for detection that have been described above can, as mentioned, be used separately or in combination with each other. Irrespective of how they are used they can be said to be a first requirement for detecting a FPT earth fault, a so called starting requirement.

To avoid making the calculations according to the first requirement mainly continuously by the CPU, the first requirement can be added with a second requirement, a trig requirement, in other words a requirement which, if fulfilled, initiates the calculation to find out if a start requirement exists. One example of how to realize such a trig requirement is, according to the invention, to calculate, in the CPU or in other ways, if there is a spontaneous change in the zero sequence current (⅓(I_{A}+I_{B}+I_{C})). If a spontaneous change in the zero sequence current (in a healthy system the zero sequence current is almost zero) exceeds a preset value the start criterion calculation takes place, and a FPT earth fault is recognized if both the trig and start requirements are fulfilled.

The change in phase currents or in the zero sequence current can, for example, be calculated by the change between 2 measurements (samples) which differ 20 ms (one 50 Hz cycle) or 16.67 ms (one 60 Hz cycle). A suitable trig level should correspond to the sensitivity one will achieve with the third requirement described below.

Depending on the prerequisites for the detection it is possible, in order to secure the reliability of the detection, to add to the trig and start requirements a third requirement, a so called "signal" requirement, to assure that the fault persists for a certain time. The calculation of this third requirement is initiated only if the two other requirements are fulfilled, and alarm (or trip) is executed only if all three requirements are fulfilled.

An appropriate signal requirement is the zero sequence current, and this condition is considered to be fulfilled if the steady state RMS-value exceeds a threshold value. In a 10 kV system, where the sensitivity should be set to be able to detect earth faults with R_{f} ≈ 5 kΩ, the signal threshold level should be set to about 1 Ampère.

In another example, the third requirement can be achieved in many different ways. If the device should be located in the feeding primary substation it should, alternatively, be possible to measure the zero sequence voltage or a digital signal from a neutral voltage protective device.

Once again it should be pointed out, that the trig, start and signal requirements can be used to be complementary to each other, or the start requirement can be used alone, all depending on different factors, for example the reliability in the detection, available processing power etc.

## Claims

1. A method to detect earth faults in an electrical distribution network with three phases, **characterised by** the step of
comparing the current change during a predefined time period in a first (A) of the phases with the sum of the current changes during the same period of time in the second (B) and third (C) phase, wherein a first requirement for an earth fault being detected is that the current change (310) in the first phase (A) during the same period of time with respect to its amplitude or phase direction in a predefined way differs from the sum of the current changes (311, 312) in the second (B) and third (C) phase in the system and wherein said earth faults are detected by measuring current only.

2. The method according to claim 1, **characterised in that** the first requirement for earth fault is fulfilled if the quotient between the amplitude of the current change in the first phase and the sum of the current change amplitudes for the second and third phase in the system exceeds a preset threshold value.

3. The method according to claim 1, **characterised in that** the first requirement is fulfilled if the current change in the first phase with respect to its phase direction differs from the phase direction of the sum of the current changes in the two other phases.

4. The method according to any of the above claims, **characterized by** a second requirement for earth fault detection, which second requirement includes the measurement of the change in zero sequence current, and where the second requirement is considered to be fulfilled if the mentioned changes within a predefined period of time exceed a preset value, whereby an earth fault is detected if the first and the second requirements both are fulfilled.

5. The method according to claim 4, **characterized by** a third requirement for earth fault detection, which third requirement includes the measurement of the zero sequence current, whereby the third requirement is considered to be fulfilled if the zero sequence steady state current exceeds a preset value, and earth fault is detected if the first, second and third requirements are fulfilled.

6. A device for earth fault detection in electrical distribution networks with three phases, **characterized by** the device (400) including means (410) arranged to compare the current change in a first of the system's phases during a predefined period of time with a sum of the current changes in the second and third phase during the same period of time, also including means (410) arranged to evaluate a first requirement which is used for an earth fault being considered detected, which first requirement includes that the current change with respect to its amplitude or phase direction in a predefined manner differs from the sum of the current changes in the second and third phase in the system and wherein said earth faults are detected by measuring current only.

7. The device (400) according to claim 6, **characterized in that** the means (410) arranged to evaluate of the first requirement are arranged to indicate that the mentioned requirement is fulfilled if the quotient between the amplitude for the current change in the first phase and the sum of the current change amplitudes in the second and third phase exceeds a predefined threshold value.

8. The device (400) according to claim 7, **characterized in that** the means (410) arranged to evaluate the first requirement are arranged for evaluation of the mentioned requirement if the current change in the first phase to its phase direction differs from the phase direction of the current changes in the two other phases.

9. The device (400) according to any of the claims 6-8, **characterised by** means (410) arranged to evaluate a second requirement for detection of earth fault, including measurement of changes in the zero sequence current, which second requirement of said means (410) is considered to be fulfilled if said changes during a predefined time exceed a preset value, whereby the device (400) is arranged to indicate said that an earth fault is detected if the first and the second requirements both are fulfilled.

10. The device (400) according to claim 9, **characterised by** means (410) arranged to evaluate a third requirement for detection of earth fault, including means arranged to measure the steady state zero sequence current, whereby the third requirement for said detecting means is considered to be fulfilled if said steady state zero sequence current exceeds a preset level, and the device (400) is arranged to indicate that an earth fault is considered to be detected if the first, the second and the third requirements are fulfilled.

## Patentansprüche

1. Verfahren zum Erfassen von Erdungsfehlern in einem elektrischen Verteilungsnetzwerk mit drei Phasen, **gekennzeichnet durch** den Schritt:
Vergleichen der Stromänderung während einer vorbestimmten Zeitspanne in einer ersten (A) der Phasen mit der Summe der Stromänderungen während derselben Zeitspanne in der zweiten (B) und dritten (C) Phase,
wobei eine erste Anforderung für das Erfassen eines Erdungsfehlers darin besteht, dass sich die Stromänderung (310) in der ersten Phase (A) während derselben Zeitspanne in Bezug auf ihre Amplitude oder Phasenrichtung in vorbestimmter Weise von der Summe der Stromänderungen (311, 312) in der zweiten (B) und dritten (C) Phase in dem System unterscheidet, und wobei die Erdfehler erfasst werden, indem lediglich Strom gemessen werden.

2. Verfahren gemäß Anspruch 1, **dadurch gekennzeichnet, dass** die erste Anforderung für Erdungsfehler erfüllt ist, falls der Quotient zwischen der Amplitude der Stromänderung in der ersten Phase und der Summe der Amplituden der Stromänderungen für die zweite und dritte Phase in dem System einen voreingestellten Schwellwert überschreitet.

3. Verfahren gemäß Anspruch 1, **dadurch gekennzeichnet, dass** die erste Anforderung erfüllt ist, falls sich die Stromänderung in der ersten Phase in Bezug auf ihre Phasenrichtung von der Phasenrichtung der Summe der Stromänderungen in den zwei anderen Phasen unterscheidet.

4. Verfahren gemäß einem der vorstehenden Ansprüche, **gekennzeichnet durch** eine zweite Anforderung für die Erfassung eines Erdungsfehlers, wobei die zweite Anforderung die Messung der Veränderung des Nullstroms einschließt, und wobei die zweite Anforderung als erfüllt betrachtet wird, falls die erwähnten Veränderungen innerhalb einer vorbestimmten Zeitspanne einen vorher festgelegten Wert überschreiten, wobei ein Erdungsfehler erfasst wird, falls sowohl die erste als auch die zweite Anforderung erfüllt ist.

5. Verfahren gemäß Anspruch 4, **gekennzeichnet durch** eine dritte Anforderung für die Erfassung eines Erdungsfehlers, wobei die dritte Anforderung die Messung des Nullstroms einschließt, und wobei die dritte Anforderung als erfüllt betrachtet wird, falls der Dauerzustand des Nullstroms einen vorher festgelegten Wert überschreitet, und wobei ein Erdungsfehler erfasst wird, falls die erste, zweite und dritte Anforderung erfüllt sind.

6. Vorrichtung zum Erfassen von Erdungsfehlern in elektrischen Verteilungsnetzwerken mit drei Phasen, **dadurch gekennzeichnet, dass** die Vorrichtung (400) Mittel (410) einschließt, die eingerichtet sind, um die Stromänderung in einer ersten der Phasen des Systems während einer vorbestimmten Zeitspanne mit einer Summe der Stromänderungen in der zweiten und dritten Phase während der selben Zeitspanne zu vergleichen, ebenfalls Mittel (410) einschließend, die eingerichtet sind, eine erste Anforderung auszuwerten, die verwendet wird, um zu betrachten, ob ein Erdungsfehler erfasst wird, wobei die erste Anforderung einschließt, dass sich die Stromänderung in Bezug auf ihre Amplitude oder Phasenrichtung in vorbestimmter Weise von der Summe der Stromänderungen in der zweiten und dritten Phase in dem System unterscheidet, und wobei die Erdungsfehler erfasst werden, indem lediglich Strom gemessen wird.

7. Vorrichtung (400) gemäß Anspruch 6, **dadurch gekennzeichnet, dass** die Mittel (410), die eingerichtet sind, um die erste Anforderung auszuwerten, um anzugeben, dass die erwähnte Anforderung erfüllt ist, falls der Quotient zwischen der Amplitude der Stromänderung in der ersten Phase und der Summe der Amplituden der Stromänderungen für die zweite und dritte Phase einen vorbestimmten Schwellwert überschreitet.

8. Vorrichtung (400) gemäß Anspruch 7, **dadurch gekennzeichnet, dass** die Mittel (410), die eingerichtet sind, die erste Anforderung auszuwerten, eingerichtet sind, um die erwähnte Anforderung auszuwerten, falls sich die Stromänderung in der ersten Phase in Bezug auf ihre Phasenrichtung von der Phasenrichtung der Stromänderungen in den zwei anderen Phasen unterscheidet.

9. Vorrichtung (400) gemäß einem der Ansprüche 6-8, **gekennzeichnet durch** Mittel (410), die eingerichtet sind, eine zweite Anforderung für die Erfassung eines Erdungsfehlers auszuwerten, die Messungen von Änderungen in dem Nullstrom einschließt, wobei die zweite Anforderung des Mittels (410) als erfüllt betrachtet wird, falls die Änderungen während einer vorbestimmten Zeit einen vorher festgelegten Wert überschreiten, wobei die Vorrichtung (400) eingerichtet ist, um anzugeben, dass ein Erdungsfehler erfasst wird, falls sowohl die erste als auch die zweite Anforderung erfüllt ist.

10. Vorrichtung (400) gemäß Anspruch 9, **gekennzeichnet durch** Mittel (410), die eingerichtet sind, eine dritte Anforderung für die Erfassung eines Erdungsfehlers auszuwerten, die Mittel einschließen, um den Dauerzustand des Nullstroms zu messen, wobei die dritte Anforderung für das Erfassungsmittel als erfüllt betrachtet wird, falls der Dauerzustand des Nullstroms ein vorher festgelegtes Niveau überschreitet und wobei die Vorrichtung (400) eingerichtet ist, um anzugeben, dass ein Erdungsfehler als erfasst betrachtet wird, falls die erste, die zweite und die dritte Anforderung erfüllt sind.

## Revendications

1. Un procédé pour détecter les défauts de mise à la terre dans un réseau de distribution électrique triphasé, **caractérisée par** l'étape consistant à Comparer les variations de courant pendant une période de temps prédéfinie dans une première (A) des phases avec la somme des variations de courant durant la même période de temps dans la seconde (B) et la troisième (C) phases, une première condition pour qu'un défaut de mise à la terre soit détecté étant que la variation de courant (310) dans la première phase (A) pendant la même période de temps par rapport à son amplitude ou à sa direction de phase d'une manière prédéfinie diffère de la somme des variations de courant (311, 312) dans la seconde (B) et la troisième (C) phases dans le système, lesdits défauts de mise à la terre étant détectés par la mesure du courant uniquement.

2. Le procédé selon la revendication 1, **caractérisé en ce que** la première condition pour qu'un défaut de mise à la terre soit atteint est que le quotient entre l'amplitude de la variation de courant dans la première phase et la somme des amplitudes de variation de courant pour la seconde et la troisième phases dans le système dépasse une valeur de seuil prédéfinie.

3. Le procédé selon la revendication 1, **caractérisé en ce que** la première condition est remplie si la variation de courant dans la première phase par rapport à sa direction de phase diffère de la direction de phase de la somme des variations de courant dans les deux autres phases.

4. Le procédé selon l'une quelconque des revendications ci-dessus, **caractérisée par** une deuxième condition pour la détection de défauts de mise à la terre, laquelle deuxième condition comprend la mesure de la variation de courant homopolaire, cette deuxième condition étant considérée comme remplie si les changements mentionnés dans une période prédéfinie dépassent une valeur prédéfinie, un défaut de mise à la terre étant détecté si la première et la deuxième condition sont toutes les deux remplies.

5. Le procédé selon la revendication 4, **caractérisée par** une troisième condition pour la détection de défauts de mise à la terre, laquelle troisième condition comprend la mesure du courant homopolaire, la troisième condition étant considérée comme remplie si le courant homopolaire à l'état stable dépasse une valeur prédéfinie, et le défaut de mise à la terre est détecté si la première, la deuxième et la troisième conditions sont remplies.

6. Un appareil de détection de défaut de mise à la terre dans les réseaux de distribution électrique triphasés, **caractérisé par le fait que** l'appareil (400) comprenne des moyens (410) agencés pour comparer les variations de courant dans une première des phases du système pendant une période de temps prédéfinie avec une somme des variations de courant dans la deuxième et la troisième phases durant la même période de temps, le système comprenant également des moyens (410) agencés pour évaluer une première condition qui est utilisée pour qu'un défaut de mise à la terre soit considéré comme détecté, laquelle première condition inclut **le fait que** la variation de courant par rapport à son l'amplitude ou sa direction de phase d'une manière prédéfinie diffère de la somme des variations de courant dans la deuxième et la troisième phases du système, lesdits défauts de mise à la terre étant détectés par la mesure du courant uniquement.

7. L'appareil (400) selon la revendication 6, **caractérisé en ce que** les moyens (410) agencés pour évaluer la première condition sont agencés pour indiquer que la condition mentionnée est remplie si le quotient entre l'amplitude de la variation de courant dans la première phase et la somme des amplitudes de variation de courant dans la deuxième et la troisième phases dépasse une valeur de seuil prédéfinie.

8. L'appareil (400) selon la revendication 7, **caractérisé en ce que** les moyens (410) agencés pour évaluer la première condition sont agencés pour l'évaluation de la condition mentionnée si la variation de courant dans la première phase par rapport à sa direction de phase diffère de la direction de phase des variations de courant dans les deux autres phases.

9. L'appareil (400) selon l'une des revendications 6 à 8, **caractérisé par** des moyens (410) agencés pour évaluer une deuxième condition pour la détection de défauts de mise à la terre, comprenant la mesure des variations dans le courant homopolaire, laquelle deuxième condition desdits moyens (410) est considérée comme remplie si lesdites variations pendant un temps prédéfini dépasse une valeur prédéfinie, l'appareil (400) étant agencé pour indiquer qu'un défaut de mise à la terre est détecté si la première et la deuxième conditions sont toutes les deux remplies.

10. L'appareil (400) selon la revendication 9, **caractérisé par** des moyens (410) agencés pour évaluer une troisième condition pour la détection d'un défaut de mise à la terre, comprenant des moyens agencés pour mesurer l'état stable du courant homopolaire, la troisième condition pour ledit moyen de détection étant considérée être remplie si ladite séquence d'état stable du courant homopolaire dépasse un niveau prédéfini, et l'appareil (400) étant agencé pour indiquer qu'un défaut de mise à la terre est considéré être détecté si la première, la deuxième et la troisième condition sont remplies.
